# EUROPÄISCHE PATENTSCHRIFT

(11) **EP 2 300 389 B1**
(45) Veröffentlichungstag und Bekanntmachung des Hinweises auf die Patenterteilung: **14.05.2014**
(21) Anmeldenummer: 09761452.3
(22) Anmeldetag: 09.06.2009
(51) Int. Cl.: C03C 17/34, H01J 37/34, C23C 14/08

(54) **GLASPRODUKT**
GLASS PRODUCT
PRODUIT DE VERRE

(30) Priorität: 13.06.2008 DE 102008028141
(43) Veröffentlichungstag der Anmeldung: 30.03.2011
(73) Patentinhaber: Volkswagen Aktiengesellschaft, 38440 Wolfsburg (DE); Audi AG, 85045 Ingolstadt (DE); Fraunhofer-Gesellschaft zur Förderung der angewandten Forschung e.V., 80686 München (DE)
(72) Erfinder: DRESCHER, Thomas, 38518 Gifhorn (DE); HANGLEITER, Bernd, 38518 Gifhorn (DE); SCHUETZ, Joachim, 38543 Hillerse (DE); MATTHAI, Annegret, 85107 Baar-Ebenhausen (DE); WALTER, Heike, 38126 Braunschweig (DE); HORSTMANN, Felix, 38118 Braunschweig (DE); SZYSZKA, Bernd, 38108 Braunschweig (DE); SITTINGER, Volker, 38106 Braunschweig (DE); WERNER, Wolfgang, 38122 Braunschweig (DE); BOENTORO, Tjhay, Weyna, 38106 Braunschweig (DE)
(74) Vertreter: Manske, Jörg
(86) Internationale Anmeldenummer: PCT/EP2009/004116
(87) Internationale Veröffentlichungsnummer: WO 2009/149889

(56) Entgegenhaltungen:
- WO-A-03/093185
- US-A1- 2007 029 186
- US-B1- 6 495 251
- SITTINGER V ET AL: "High power pulsed magnetron sputtering of transparent conducting oxides" THIN SOLID FILMS, ELSEVIER-SEQUOIA S.A. LAUSANNE, CH, [Online] Bd. 516, Nr. 17, 16. Oktober 2007 (2007-10-16), Seiten 5847-5859, XP022688406 ISSN: 0040-6090

## Beschreibung

Die vorliegende Erfindung bezieht sich auf ein Glasprodukt, umfassend ein Glassubstrat mit einer transparenten und leitfähigen Indiumzinnoxidschicht, die eine Deckschicht aufweist, welche eine Redoxbarriere für die Indiumzinnoxidschicht bildet.

Das Vereisen von Außenverglasungen sowie Außenspiegeln von Kraftfahrzeugen durch Kondensation von Wasserdampf und nachfolgende Eisbildung ist ein seit Jahrzehnten in der Kraftfahrzeugtechnik bekanntes Problem. Durch die immer geringeren U_{g}-Werte der der Verglasungen im Architekturbereich tritt dieses Problem dort ebenfalls in zunehmendem Maße auf. Neben Komforteinbußen ergeben sich im Fahrzeugglasbereich darüber hinaus auch sicherheitstechnische Nachteile.

Unter Verzicht auf manuelles Wischen beziehungsweise Eiskratzen kann eine beschlagbeziehungsweise eisfreie Glasoberfläche prinzipiell auf mehreren unterschiedlichen Wegen erhalten werden. In diesem Zusammenhang sind insbesondere die nachfolgend genannten Konzepte praktisch relevant
(i.) das Abperlen von kondensierter Feuchtigkeit noch bevor eine Eisbildung erfolgt durch eine superhydrophobe Ausführung der Verglasung,
(ii.) das schnelle Abtauen der Verglasung durch eine im Wesentlichen vollflächige elektrische Scheibenheizung,
(iii.) das Unterdrücken der Kondensation von Feuchtigkeit auf der Außenoberfläche der Verglasung durch eine Außenbeschichtung, die eine niedrige thermische Emissivität aufweist.

Eine superhydrophobe Beschichtung der Verglasung kann eine Eisbildung prinzipiell verhindern, da die auf schrägen Flächen kondensierte Feuchtigkeit Tröpfchen bildet, die bei hinreichender Hydrophobie (Größenordnung: Wasserkontaktwinkel > 160°) und hinreichender Hangabtriebskraft abperlen. Ein Nachteil superhydrophober Außenbeschichtungen eines Glasprodukts besteht darin, dass sie eine unzureichende mechanische und chemische Beständigkeit aufweisen, die eine technische Umsetzung im Kraftfahrzeugbau bislang verhindert haben.

Eine vollflächige elektrische Heizung einer Fahrzeugaußenverglasung ermöglicht ebenfalls das Abtauen entsprechend dem seit langem bekannten Konzept der elektrisch heizbaren Heckscheibe. Für vollflächige elektrisch beheizbare Fahrzeugverglasungen existieren im Stand der Technik bereits entsprechende Lösungen für Verbundverglasungen unter Verwendung einlaminierter Drahtgewebe oder unter Verwendung der vorhandenen Ag-basierten Sonnenschutzbeschichtungen der Außenverglasungen. Hier wird insbesondere die Kostenproblematik als kritisch bewertet, da neben der Einschränkung auf Verbundverglasungen vor allem auch eine leistungsfähige elektrische Stromversorgung im Kraftfahrzeug vorgesehen werden muss, um die vollflächige Scheibenheizung zu betreiben.

Eine Außenbeschichtung mit niedriger thermischer Emissivität ist grundsätzlich dazu geeignet, die Eisbildung auf der Oberfläche eines Glasprodukts bei typischen Beschlags- und Vereisungssituationen wirksam zu verhindern. Ansatzpunkt ist hierbei die Verringerung der thermischen Emissivität von ε = 0.85 für das unbeschichtete Glassubstrat auf ε < 0.3 nach dem Aufbringen der Beschichtung mit niedriger thermischer Emissivität. Diese Maßnahme verringert das Abkühlen der Oberfläche des Glasprodukts durch Strahlungsaustausch mit dem Himmel, so dass der Taupunkt im Bereich der Oberfläche gegenüber der Umgebung mit einer zeitlichen Verzögerung unterschritten wird. Insgesamt führt dies dazu, dass die in der Atmosphäre vorhandene Feuchtigkeit nicht mehr auf dem Glas, sondern in anderen Bereichen (beispielsweise in der Umgebung oder auf lackierten Flächen des Kraftfahrzeugs) kondensiert.

Das Konzept einer Außenbeschichtung mit niedriger thermischer Emissivität zur Verhinderung der Eisbildung auf einer Außenoberfläche eines Glasprodukts wurde in der Vergangenheit an verschiedenen Stellen bereits untersucht. So ist dieses Konzept zum Beispiel im Bereich der Architekturglas-Beschichtung seit Jahren relevant, da hoch wärmedämmende Fenster im Gegensatz zu schlechter isolierenden Fenstern zu einer Taubildung neigen. Häufig sind in diesem Zusammenhang optische Funktionsschichten auf Basis von SnO₂ eingesetzt worden, die sich in der industriellen Anwendung aufgrund ihrer vorteilhaften chemischen und mechanischen Eigenschaften bereits bewährt haben. Seit den vierziger Jahren des vergangenen Jahrhunderts werden zum Beispiel spraypyrolytisch hergestellte Beschichtungen auf Basis von SnO₂:F als niedrig emittierende Heizscheiben im Flugzeugbau eingesetzt. Gleichfalls werden transparente und leitfähige SnO₂:F-Schichten im Bereich der Architekturglas-Beschichtungen als niedrig emittierende Innenbeschichtung verwendet (vgl. Gläser J. H.: Dünnfilmtechnologie auf Flachglas, Kapitel 5.1.3.2, Verlag Karl Hofmann, ISBN 3-7780-1041-7, Schondorf (1999)), um dadurch die Kondensation von Feuchtigkeit auf der Innenseite der Verglasung zu unterdrücken. Die Taubildung auf einer Verglasung kann somit durch eine Außenbeschichtung mit niedriger thermischer Emissivität auf Basis pyrolytisch hergestellter SnO₂:F-Funktionsschichte gezielt unterdrückt werden. Es hat sich allerdings gezeigt, dass Glasprodukte mit einer relativ rauen, pyrolytisch hergestellten SnO₂:F-Beschichtung für eine Verwendung im Fahrzeugbau nicht geeignet sind, da sie eine unzureichende mechanische Stabilität sowie unzureichende optische Eigenschaften aufweisen.

Niedrig emittierende Schichten auf Außenverglasungen eines Kraftfahrzeugs können den Tau- beziehungsweise Reifbeschlag also grundsätzlich verhindern. Die mit den aus dem Stand der Technik bekannten Verfahren hergestellten niedrig emittierenden Beschichtungen eines Glasprodukts leiden jedoch unter einer ungenügenden Stabilität des Schichtsystems, welches bereits bei der Herstellung eine erhöhte Trübung ("Haze") zeigt oder aber durch eine Beanspruchung zu einer erhöhten Trübung führt. Ein Grund für die unzureichende Stabilität ist unter anderem die vergleichsweise raue Oberfläche bei Glasprodukten mit einer Außenbeschichtung auf Basis von mit Fluor dotiertem SnO₂ und der damit einhergehenden Trübung. Bisher konnte auf Basis anderer leitfähiger Metalloxide ebenfalls kein Produkt mit ausreichend hoher mechanischer und chemischer Stabilität bei gleichzeitig hoher optischer Transmission und ebenfalls hoher elektrischer Leitfähigkeit hergestellt werden.

Ein Beispiel für transparente leitfähige Beschichtungen (kurz: TCO- Beschichtungen; TCO = Transparent Conductive Oxide) eines Substrats ist eine Indiumzinnoxidschicht (ITO-Schicht), die bei den aus dem Stand der Technik bekannten Verfahrens allerdings bei Substrattemperaturen von etwa 300°C hergestellt werden muss, um eine ausreichend gute mechanische und chemische Stabilität sowie gute elektrische und optische Funktionseigenschaften zu erhalten.

Werden ITO-Schichten demgegenüber bei Raumtemperatur hergestellt und in einem anschließenden Temperprozess vollständig kristallisiert, muss die Degradation der TCO-Schichten durch eine geeignete Deckschicht verhindert werden, wie es zum Beispiel in der EP 0 500 445 B1 beschrieben ist. In der vorstehend genannten Druckschrift wird ein Verfahren zur Herstellung einer leitfähigen Metalloxidschicht auf einem Glassubstrat beschrieben, wobei die Metalloxidschicht einer thermischen Behandlung vom Typ Biegen/Vorspannen/Härten ausgesetzt wird. Zum Schutz der Metalloxidschicht vor einer Oxidation wird eine Deckschicht auf die Metalloxidschicht aufgebracht. Diese Deckschicht kann beispielsweise aus Aluminiumoxid, Titandioxid, Zinkoxid, Zirkoniumoxid, Chromoxid oder Siliziumdioxid bestehen. In der WO 03/093185 A1 sind darüber hinaus Barriereschichten für TCO-basierte Schichtsysteme aus Metalloxid, - nitrid und -oxynitrid offenbart.

Die WO 03/093185 A1 offenbart ein Glasprodukt, das ein Glassubstrat mit einer Indiumzinnoxidschicht und einer Redoxbarrierendeckschicht umfasst.

Ein Verfahren zur Herstellung einer transparenten und leitfähigen Indiumzinnoxidschicht auf einem Substrat, bei dem zumindest ein Bestandteil der Metalloxidschicht durch hochionisierendes, gepulstes Hochleistungsmagnetronsputtern zerstäubt wird, wird in V. Sittinger et al. "High power pulsed magnetron sputtering of transparent conducting oxides" (in: "Thin Solid Films", Band 516 (2008), S. 5847 bis 5859) beschrieben. Die Pulse haben Pulsdauern, die kleiner als 200 us sind, und weisen eine Peakleistungsdichte von bis zu 1,5 kW/cm² auf.

Die aus dem Stand der Technik bekannten Glasprodukte mit einer niedrig emittierenden, transparenten und leitfähigen Beschichtung haben den Nachteil, dass sie den mechanischen und optischen Anforderungen, die an Außenverglasungen von Kraftfahrzeugen gestellt werden, nicht genügen.

Hier setzt die vorliegende Erfindung an.

Der vorliegenden Erfindung liegt die Aufgabe zugrunde, ein Glasprodukt der eingangs genannten Art mit einer niedrig emittierenden, transparenten und leitfähigen Indiumzinnoxidschicht zur Verfügung zu stellen, das eine hohe mechanische und chemische Stabilität sowie eine hohe optische Transmission aufweist und insbesondere für die Herstellung von Außenverglasungen oder Außenspiegeln von Kraftfahrzeugen geeignet ist.

Die Lösung dieser Aufgabe liefert ein Glasprodukt der eingangs genannten Art mit den Merkmalen des kennzeichnenden Teils des Anspruchs 1. Die Unteransprüche betreffen vorteilhafte Weiterbildungen der Erfindung.

Erfindungsgemäß ist vorgesehen, dass die Indiumzinnoxidschicht auf einer Oberfläche des Glassubstrats durch gepulstes, hochionisierendes Hochleistungs-Magnetronsputtern (kurz: HPPMS), bei dem
- die Pulse des Magnetrons eine Peakleistungsdichte aufweisen, die größer als 1,5 kW/cm² ist,
- die Pulse des Magnetrons eine Zeitdauer haben, die s 200 µs ist, sowie
- der mittlere Stromflussdichteanstieg beim Zünden des Plasmas innerhalb eines Zeitintervall, das ≤ 0.025 ms ist, mindestens 106 A/(ms cm²) beträgt,
erhalten wird und die Indiumzinnoxidschicht eine kristalline Struktur aufweist, derart, dass der (222)-Reflex eines Röntgenbeugungsspektrums nach dem Erzeugen der Indiumzinnoxidschicht gegenüber dem Pulverspektrum von Indiumzinnoxid um maximal 1 °, vorzugsweise um 0,3° bis 0,5°, in Richtung Druckspannung verschoben ist und nach dem Tempern um maximal 1°, vorzugsweise um 0,2° bis 0,4°, in Richtung des Pulverspektrums verschoben ist. Es wird deutlich, dass die Indiumzinnoxidschicht des erfindungsgemäßen Glasprodukts vor dem Tempern einen verspannten Schichtaufbau aufweist und nach dem Tempern wieder relaxiert ist. Dabei ist es besonders vorteilhaft, wenn die Halbwertsbreite des (222)-Reflexes des Röntgenbeugungsspektrums möglichst breit ist und insbesondere vor und nach dem Tempern im Wesentlichen konstant ist. Die kristalline Indiumzinnoxidschicht des erfindungsgemäßen Glasprodukts wird bei einer Temperatur T ≤ 100°C - vorzugsweise bei Raumtemperatur - auf der Oberfläche des Glassubstrats erzeugt. Vorzugsweise relaxiert die Indiumzinnoxidschicht nach dem Tempern vollständig. Für manche Anwendungen kann es jedoch auch vorteilhaft sein, wenn auch nach dem Tempern eine kleine Druckspannung in der Indiumzinnoxidschicht erhalten bleibt.

Beim gepulsten Hochleistungs-Magnetronsputtern erfolgt die Bildung der Indiumzinnoxidschicht durch physikalische Gasphasenabscheidung (englisch: Physical Vapour Deposition, PVD). Es hat sich gezeigt, dass durch gepulstes Hochleistungs-Magnetronsputtern (HPPMS) Indiumzinnoxidschichten mit besonders vorteilhaften mechanischen, chemischen und optischen Eigenschaften hergestellt werden können. Dabei handelt es sich um einen gepulsten Prozess, bei dem die Leistungsdichte am Festkörper-Target etwa das 30- bis 100-fache der beim herkömmlichen DC-Magnetronsputtern üblichen Werte erreichen kann. Ferner sind Leistungsdichten weit oberhalb von 1 kW/cm² möglich. Unter solchen Prozessbedingungen wird die Magnetron-Entladung im Übergang zur Lichtbogenentladung betrieben. Hierdurch kommt es zu einer erhöhten Ionisation des gesputterten Targetmaterials, das anschließend auf dem Glassubstrat kondensiert. Die im Stand der Technik häufig anzutreffende Problematik der ungenügenden Stabilität eines Glasprodukts, das beispielsweise zur Herstellung von Außenverglasungen oder Außenspiegeln eines Kraftfahrzeugs eingesetzt werden kann, mit einer niedrig emittierenden, transparenten und leitfähigen Außenbeschichtung kann in besonders vorteilhafter Weise durch die Verwendung des Hochleistungs-Magnetronsputterverfahrens mit den angegebenen Prozessparametern zur Herstellung der Indiumzinnoxidschicht gelöst werden, welches sich durch einen hohen Ionisationsgrad und durch eine erhöhte kinetische Energie des schichtbildenden Teilchenstroms beim Auftreffen auf das zu beschichtende Substrat auszeichnet. Dadurch wird zum einen die Beweglichkeit der adsorbierten Teilchen auf der Oberfläche des Substrates erhöht und zum anderen werden ebenfalls die Energieeinträge durch die zusätzlichen reflektierten Neutralteilchen und durch die am Target gebildeten negativen Sauerstoffionen, die gleichfalls auf die Schicht auftreffen, stark erhöht. Somit können unter bestimmten Puls- und Leistungsbedingungen bereits bei Raumtemperatur kleinkristalline Schichtstrukturen aus Indiumzinnoxid auf der Glassubstratoberfläche gebildet werden. Hierzu ist eine Leistungstromdichte erforderlich, die gegenüber einer konventionellen DC-Entladung (3 - 10 W/cm²) um einen Faktor 100 - 500 größer ist (vorzugsweise 1,5 kW/cm² und höher). Des Weiteren müssen die Pulsdauern klein (vorzugsweise < 40 µs, insbesondere etwa 20 µs) gehalten werden. Weiterhin muss der so genannte Duty Cycle klein (vorzugsweise < 5%) gehalten werden, um das Target während des Zerstäubens nicht zu überlasten. Es hat sich gezeigt, dass die Puls- und Leistungsparameter hierbei entscheidend sind, um mechanisch und chemisch stabile Schichtstrukturen aus Indiumzinnoxid auf der Glassubstratoberfläche zu erzeugen.

Das Tempern des Glasprodukts kann zum Beispiel durch einen Einscheibensicherheitsglas- beziehungsweise Verbund-Sicherheitsglas-Temperprozess (ESG- beziehungsweise VSG-Temperprozess) bei einer Temperatur von etwa 650°C bis 750° C erfolgen. Vorzugsweise behält die Indiumzinnoxidschicht nach dem Temperprozess die Kristallinität sowie die Kristallitgröße nahezu bei. In einer besonders vorteilhaften Ausführungsform ist vorgesehen, dass etwa 80% der Korngröße der Indiumzinnoxidschicht kleiner als 30 nm, insbesondere kleiner als 25 nm ist. Die laterale Korngröße der Indiumzinnoxidschicht ist in einer bevorzugten Ausführungsform vor und nach dem Tempern im Wesentlichen konstant. In einer besonders vorteilhaften Ausführungsform wird vorgeschlagen, dass die Korngrößenverteilung lateral/vertikal kleiner als 40nm (vorzugsweise kleiner als 25 nm) ist.

Das Glasprodukt weist nach der Beschichtung mit der niedrig emittierenden, transparenten und leitfähigen Indiumzinnoxidbeschichtung und der Deckschicht eine thermische Emissivität ε < 0.3 (insbesondere 0.25 (0,12) bei einem Schichtwiderstand von 20 (10) Ohm) auf. Somit kann die Eisbildung auf der Oberfläche des Glasprodukts bei typischen Beschlags- und Vereisungssituationen wirksam verhindert werden. Das Glasprodukt eignet sich somit insbesondere zur Herstellung mechanisch und chemisch stabiler Außenverglasungen oder Außenspiegel von Kraftfahrzeugen.

Ein besonderer Vorteil des hier vorgestellten Glasprodukts besteht darin, dass die Indiumzinnoxidschicht nach dem Einscheibensicherheitsglas- beziehungsweise Verbund-Sicherheitsglas-Temperprozess (ESG- beziehungsweise VSG-Temperprozess) und/oder Biegeprozess keinerlei Risse und nur eine sehr geringe Trübung ("Haze") aufweist und darüber hinaus eine gute Leitfähigkeit bei gleichzeitig hoher mechanischer und chemischer Stabilität und ebenfalls hoher optischer Transmission aufweist. Dadurch unterscheidet sich das Glasprodukt mit einer derartigen Indiumzinnoxidschicht in einem ganz erheblichen Maße vom Stand der Technik. Die Indiumzinnoxidschicht weist nach der Herstellung bei Raumtemperatur eine Morphologie/Textur auf, die nach dem ESGbeziehungsweise VSG-Temperprozess zu besonders vorteilhaften Schichteigenschaften führt. Diese vorteilhaften Eigenschaften spiegeln sich gleichfalls in einer bestimmten Struktur der Indiumzinnoxidschicht wieder. Durch die mit Hilfe des Hochleistungs-Magnetronsputterverfahrens eingestellte Textur und Morphologie, kann die Indiumzinnoxidschicht die im anschließenden durchgeführten Temperschritt (ESG/VSG-Prozess) benötigten Eigenschaften erreichen sowie einen durchgeführten Biegeprozess ohne Beschädigung überstehen.

In einer bevorzugten Ausführungsform wird vorgeschlagen, dass die Indiumzinnoxidschicht eine Schichtdicke aufweist, die ≤ 300 nm ist. In einer besonders bevorzugten Ausführungsform wird vorgeschlagen, dass die Indiumzinnoxidschicht eine Schichtdicke zwischen 130 und 150 nm, insbesondere eine Schichtdicke von etwa 140 nm aufweist. Es hat sich gezeigt dass die Indiumzinnoxidschicht bei einer Schichtdicke von 140 nm eine besonders hohe Transparenz aufweist.

In einer bevorzugten Ausführungsform wird vorgeschlagen, dass die Deckschicht eine Schichtdicke zwischen 5 nm und 60 nm (vorzugsweise zwischen 10 nm und 40 nm) aufweist. Um die optischen Eigenschaften des Glasprodukts weiter zu verbessern, wird in einer vorteilhaften Ausführungsform vorgeschlagen, dass die Deckschicht bei einer Wellenlänge von 550 nm einen Brechungsindex zwischen 1.50 und 1.95 aufweist. Vorzugsweise wird die Deckschicht durch DC-Magnetronsputtern hergestellt.

In einer bevorzugten Ausführungsform ist vorgesehen, dass die Deckschicht eine Siliziumoxynitrid-Schicht ist. Eine Siliziumoxynitrid-Schicht ist in vorteilhafter Weise dazu geeignet, die Indiumzinnoxidschicht während eines Temperschritts (zum Beispiel bei dem Einscheibensicherheitsglas- beziehungsweise Verbund-Sicherheitsglas-Temperprozess, ESG-Prozess/VSG-Temperprozess) vor Oxidation zu schützen, da sie eine Redoxbarriere für die Indiumzinnoxidschicht bildet.

In einer vorteilhaften Ausführungsform ist vorgesehen, dass die Siliziumoxynitrid-Schicht einen prozentualen Gehalt der Elemente:

| | | | |
|---|---|---|---|
| Silizium : | 25 bis 50 % | Kohlenstoff : | 0 bis 15% |
| Sauerstoff : | 10 bis 30 % | Fluor : | 0 bis 30 % |
| Stickstoff : | 0 bis 50 % | Aluminium : | 0 bis 20 % |

aufweist.

Um besonders vorteilhafte Eigenschaften der Deckschicht zu erhalten, wird in einer besonders bevorzugten Ausführungsform vorgeschlagen, dass die Siliziumoxynitrid-Schicht einen prozentualen Gehalt der Elemente:

| | | | |
|---|---|---|---|
| Silizium : | 35% ± 5% | Kohlenstoff : | < 5% |
| Sauerstoff : | 18% ± 5% | Fluor : | < 5% |
| Stickstoff : | 35% ± 5% | Aluminium : | 4% ± 2% |

aufweist.

Es hat sich zum Beispiel gezeigt, dass durch die Einbringung des Fluor- und Kohlenstoffanteils der Siliziumoxynitrid-Schicht die Oberflächenenergie in vorteilhafter Weise gezielt verändert werden kann.

In einer besonders vorteilhaften Ausführungsform ist vorgesehen, dass das Glasprodukt nach einer Verschleißprüfung durch ein Reibradverfahren mit Streulichtmessung gemäß DIN 52 347 (1987) einen Streulichtanteil aufweist, der kleiner als 2,5 % ist. Vorzugsweise ist der Streulichtanteil kleiner als 2,0 %.

Es hat sich beispielsweise gezeigt, dass eine Indiumzinnoxidschicht mit einer Dicke von 140nm, bei der sie eine besonders hohe Transparenz aufweist, nach einem ESG-/VSG-Temperprozess und/oder Biegeprozess eine gute Leitfähigkeit (< 300 µΩcm) bei gleichzeitig hoher Transmission und ebenfalls hoher mechanischer und chemischer Stabilität aufweist. Damit eignet sich ein Glasprodukt, das ein Glassubstrat mit einer derartigen Indiumzinnoxidschicht sowie eine Deckschicht aus Siliziumoxynitrid aufweist, in besonders vorteilhafter Weise für die Herstellung einer niedrig emittierenden Außenverglasung oder eines Außenspiegels eines Kraftfahrzeugs.

Weitere Merkmale und Vorteile der vorliegenden Erfindung werden deutlich anhand der nachfolgenden Beschreibung bevorzugter Ausführungsbeispiele unter Bezugnahme auf die beiliegenden Abbildungen. Darin zeigen
- Fig. 1: die Ergebnisse von Verschleißprüfungen an einer Floatglasprobe und an Floatglasproben, die durch gepulstes Hochleistungs-Magnetronsputtern (HPPMS) mit einer niedrig emittierenden, transparenten und leitfähigen Indiumzinnoxidschicht beschichtet wurden,
- Fig. 2: die Ergebnisse von Röntgendiffraktometrie-Messungen an unterschiedlich hergestellten Indiumzinnoxidschichten auf einem Floatglassubstrat;
- Fig. 3: die Ergebnisse der Bestimmung der Korngrößen der Proben gemäß Fig. 2;
- Fig. 4: die Änderung der Schichtzusammensetzung einer Siliziumoxynitrid-Deckschicht des Glasprodukts bei einer Änderung des CF₄-Flusses;
- Fig. 5: die Änderung des Brechungsindex der Deckschicht des Glasprodukts in Abhängigkeit vom CF₄-Fluss bei einer Wellenlänge von 550 nm.

Nachfolgend sollen die besonderen Eigenschaften verschiedener Glasprodukte gemäß bevorzugter Ausführungsbeispiele der vorliegenden Erfindung mit einer niedrig emittierenden, transparenten und leitfähigen Indiumzinnoxidschicht und einer Deckschicht, welche eine Redoxbarriere für die Indiumzinnoxidschicht bildet, näher erläutert werden.

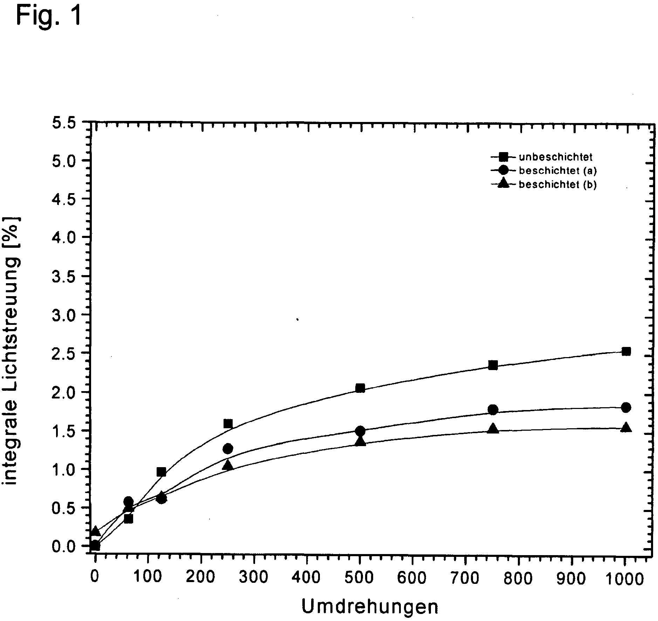

In Fig. 1 sind zunächst die Ergebnisse von Verschleißprüfungen an einer unbeschichteten Floatglasprobe sowie an zwei Floatglasproben, die durch gepulstes Hochleistungs-Magnetronsputtern (HPPMS) mit einer niedrig emittierenden, transparenten und leitfähigen Indiumzinnoxidschicht beschichtet wurden, dargestellt. Die Messergebnisse geben Aufschluss über den Verschleiß der Proben nach einer bestimmten mechanischen Belastung. Das hierbei zur Herstellung der Indiumzinnoxidschichten eingesetzte hochionisierende Hochleistungs-Magnetronsputtern (HPPMS) zeichnet sich insbesondere dadurch aus, dass
- die Pulse des Magnetrons eine Peakleistungsdichte aufweisen, die größer als 1,5 kW/cm² ist,
- die Pulse des Magnetrons eine Zeitdauer haben, die s 200 µs ist, sowie
- der mittlere Stromflussdichteanstieg beim Zünden des Plasmas innerhalb eines Zeitintervall, das ≤ 0.025 ms ist, mindestens 106 A/(ms cm²) beträgt.

Die Verschleißprüfungen erfolgten mittels eines Reibradverfahrens mit Streulichtmessung gemäß DIN 52 347 (1987). Dieses Prüfverfahren wird häufig auch als "Taber-Test" bezeichnet. Die Proben werden, wie in der DIN 52 347 (1987) näher erläutert, auf einem Drehteller der Verschleißprüfeinrichtung durch zwei sich in entgegengesetzter Richtung drehende Reibräder auf Gleitverschleiß beansprucht. Messgröße für den Verschleißgrad der Proben ist der Streulichtanteil des transmittierten Lichts, der durch Oberflächenveränderungen hervorgerufen wird und zu einer Trübung der Proben führt. Aufgetragen ist die integrale Lichtstreuung, die ein Maß für die Trübung der Probe ist, in Abhängigkeit von der Anzahl der Umdrehungen des Drehtellers der normgerechten Verschleißprüfeinrichtung.

Die Verschleißmessungen zeigen, dass die integrale Lichtstreuung bei den beschichteten Proben vor Beginn der Verschleißmessungen höher ist als bei der unbeschichteten Floatglasprobe. Bei sämtlichen Proben erhöht sich der Streulichtanteil mit zunehmender Anzahl der Umdrehungen des Drehtellers der Verschleißprüfeinrichtung. Nach 1000 Umdrehungen ist der Streulichtanteil der unbeschichteten Floatglasprobe > 2,5 %, wohingegen der Streulichtanteil der beschichteten Floatglasproben jeweils < 2,5 % ist. Es können sogar Streulichtanteile erreicht werden, die < 2,0 % sind.

Somit wird deutlich, dass sich ein entsprechendes Glasprodukt, dessen Indiumzinnoxidschicht - wie im Rahmen dieser Anmeldung erläutert - durch gepulstes Hochleistungs-Magnetronsputtern (HPPMS) erzeugt wurde, auf Grund der vergleichsweise geringen Trübung, die selbst nach einer Vielzahl mechanischer Belastungszyklen < 2,5 % ist, für die Verwendung im Fahrzeugbau und insbesondere zur Herstellung von Außenverglasungen oder Außenspiegeln eignet.

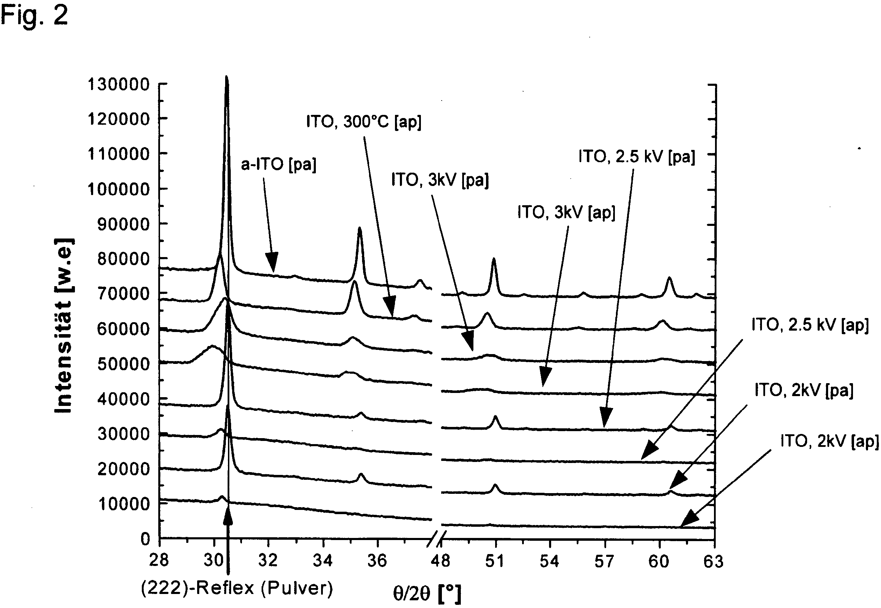

Fig. 2 zeigt mehrere Röntgendiffraktometrie-Aufnahmen (XRD-Aufnahmen mit Bragg-Brentano Geometrie) unterschiedlich hergestellter Indiumzinnoxidschichten, die jeweils auf ein Floatglassubstrat aufgebracht wurden. Dabei wurde zunächst mit Hilfe eines herkömmlichen DC-Magnetronsputterverfahrens eine amorphe ITO-Probe (a-ITO) durch Zugabe von Wasserstoff hergestellt und in einem nachfolgenden Temperschritt - ähnlich wie bei einem Einscheibensicherheitglas-Temperprozess - auf eine Temperatur von 650°C erhitzt und dadurch kristallisiert. Die Ergebnisse der Messungen an dieser Probe sind in Fig. 2 mit a-ITO [pa] besteht. Dabei steht die Abkürzung "pa" für "post annealed" (= nach dem Ausheilen). Darüber hinaus wurde mit Hilfe eines herkömmlichen DC-Magnetronsputterverfahrens eine Indiumzinnoxidschicht bei Substrattemperaturen von 300°C auf dem Floatglassubstrat erzeugt. Die Ergebnisse der Messungen an dieser Probe sind in Fig. 2 mit ITO 300°C [ap] besteht. Dabei steht die Abkürzung "ap" für "as prepared" (= wie hergestellt).

Ferner wurden mehrere Proben durch gepulstes Hochleistungs-Magnetronsputtern bei Raumtemperatur hergestellt (ITO [ap]) und anschließend getempert (ITO [pa]). Bei den mit Hilfe des HPPMS-Verfahrens hergestellten Proben wurde jeweils der Parameter der Ladespannung verändert (2 kV, 2,5 kV, 3 kV). Dabei führt eine Zunahme der Ladespannung zu einer Erhöhung der Leistungsdichte.

Ein Vergleich der XRD-Messungen zeigt, dass die a-ITO [pa] Probe den größten (222)-Reflex aufweist. Die HPPMS-Proben zeigen nach der Herstellung ([ap]) bei einer Erhöhung der Ladespannung eine Zunahme der Intensität der (222)-Reflexe. Die Proben zeigen nach dem Tempern ([pa]) für die niedrige Ladespannung eine Zunahme der Kristallinität und damit des (222)-Reflexes. Bei der höchsten Ladespannung von 3 kV ist außer einer Verschiebung des (222)-Reflexes zu höheren Winkeln kaum eine Änderung der Intensität festzustellen. Die Verschiebung des Reflexes führt zu einer unverspannten Probe. Dies ist anhand der in Fig. 2 als vertikale Linie eingezeichneten Lage des (222)-Reflexes eines ITO-Pulvers zu erkennen.

Im Gegensatz zu der bei 300°C mittels des herkömmlichen DC-Magnetronsputterverfahrens hergestellten Indiumzinnoxidbeschichtung relaxieren alle durch das HPPMS-Verfahren hergestellten Proben und haben Ihren (222)-Reflex bei einer Position, wie sie auch bei dem ITO-Pulverdiffraktogramm auftritt. Vorzugsweise ist die Halbwertsbreite (FWHM) des (222)-Peaks bei einer 140 nm dicken Indiumzinnoxidschicht vor und nach dem Tempern möglichst breit und insbesondere konstant. Die Indiumzinnoxidschicht weist nach der Erzeugung auf dem Substrat eine Verspannung auf, so dass der (222)-Reflex nach dem Herstellen der Schicht gegenüber dem Pulverspektrum von Indiumzinnoxid um maximal 1° (vorteilhaft um 0,3° bis 0,5°) in Richtung Druckspannung verschoben ist. Nach dem Tempern ist eine Verschiebung des (222)-Reflexes um maximal 1° (vorteilhaft um 0,2° bis 0,4°) in Richtung des Pulverspektrums zu beobachten. Vorzugsweise relaxiert die Indiumzinnoxidschicht nach dem Tempern vollständig. Für manche Anwendungen kann es jedoch auch vorteilhaft sein, dass auch nach dem Tempern eine kleine Druckspannung in der Indiumzinnoxidschicht erhalten bleibt.

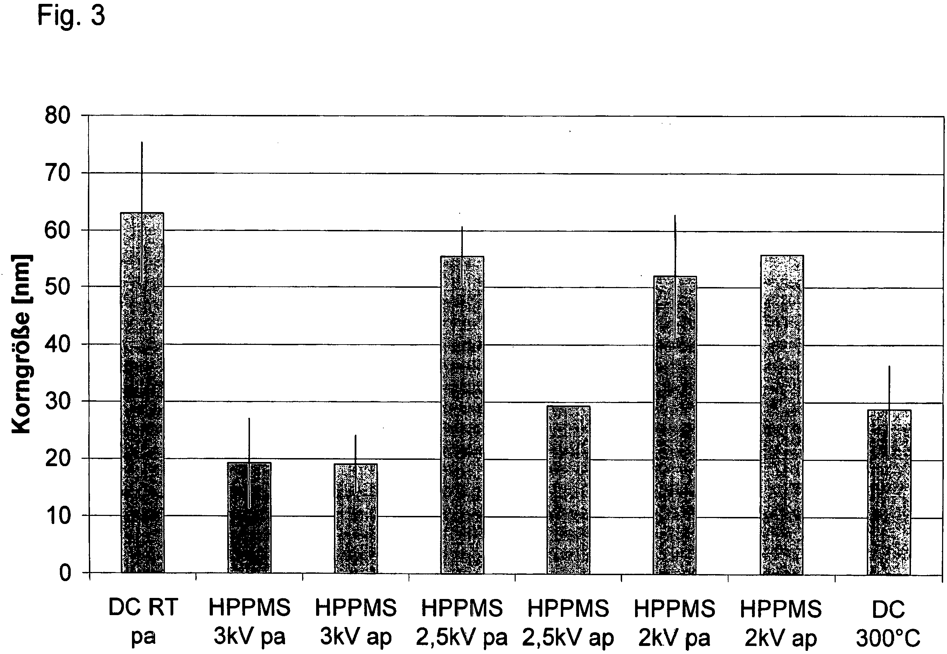

Aus den in Fig. 2 gezeigten Reflexen kann die vertikale Korngröße der Proben bestimmt werden. Die Ergebnisse dieser Korngrößenbestimmung sind in Fig. 3 zusammengefasst. Es wird deutlich, dass die HPPMS-Proben, die mit der größten Ladespannung (3 kV) hergestellt wurden, die kleinste Kristallitgröße (< 20 nm) von allen untersuchten Proben aufweisen. Die Messungen zeigen ferner, dass die Kristallitgröße vor und nach dem Tempern nahezu unverändert ist. Wenn die Schichtmorphologie der Proben durch Rasterelektronenmikroskopie (REM) untersucht wird, so zeigt sich, dass die HPPMS-Proben im Vergleich zu einer bei 300 °C durch herkömmliches DC-Magnetronsputtern hergestellten Probe eine kleinere laterale Kristallitgröße aufweisen.

Die Indiumzinnoxidschicht des Glasprodukts weist eine Deckschicht zum Schutz vor Oxidation während eines Temperschritts (zum Beispiel bei einem Einscheibensicherheitsglas- beziehungsweise Verbund-Sicherheitsglasprozess, ESG-Prozess/VSG-Prozess) auf. Diese Deckschicht bildet eine Redoxbarriere für die Indiumzinnoxidschicht und kann insbesondere eine Siliziumoxynitrid-Schicht sein, die gegebenenfalls mit Fluor und/oder Aluminium dotiert sein kann. Die Deckschicht wird vorzugsweise durch DC-Magnetronsputtern hergestellt und weist eine Schichtdicke zwischen 5 nm und 60 nm auf. Im Vergleich dazu weist die Indiumzinnoxidschicht eine Schichtdicke auf, die ≤ 300 nm ist. Vorzugsweise kann die Indiumzinnoxidschicht eine Schichtdicke zwischen 130 und 150 nm, insbesondere eine Schichtdicke von etwa 140 nm, aufweisen. Es hat sich gezeigt dass die Indiumzinnoxidschicht bei einer Schichtdicke von 140 nm eine besonders hohe Transparenz aufweist.

Um besonders vorteilhafte Eigenschaften der Deckschicht zu erhalten, kann vorgesehen sein, dass die Siliziumoxynitrid-Schicht einen prozentualen Gehalt der Elemente:

| | | | |
|---|---|---|---|
| Silizium : | 35% ± 5 % | Kohlenstoff: | < 5% |
| Sauerstoff : | 18% ± 5% | Fluor : | < 5% |
| Stickstoff : | 35% ± 5% | Aluminium : | 4% ± 2% |

aufweist.

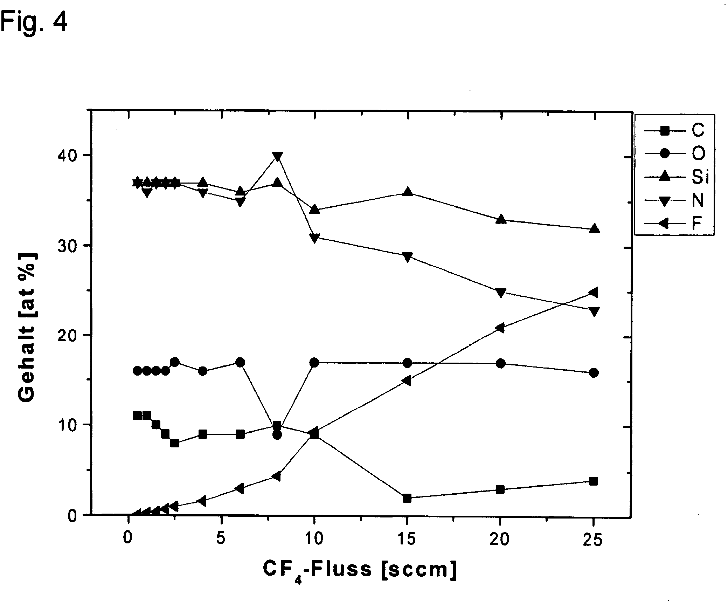

In Fig. 4 ist die Änderung der Schichtzusammensetzung der Siliziumoxynitrid-Schicht in Abhängigkeit von der Änderung des CF₄-Flusses (in Standardkubikzentimeter pro Minute, sccm) während des Sputterprozesses gezeigt. Es wird deutlich, dass der Fluor-Anteil in der Schichtzusammensetzung stetig verändert werden kann. Durch eine Anpassung des Kohlenstoff-Anteils und des Fluor-Anteils der Siliziumoxynitrid-Schicht kann die Oberflächenspannung gezielt verändert und damit an unterschiedliche Gegebenheiten angepasst werden.

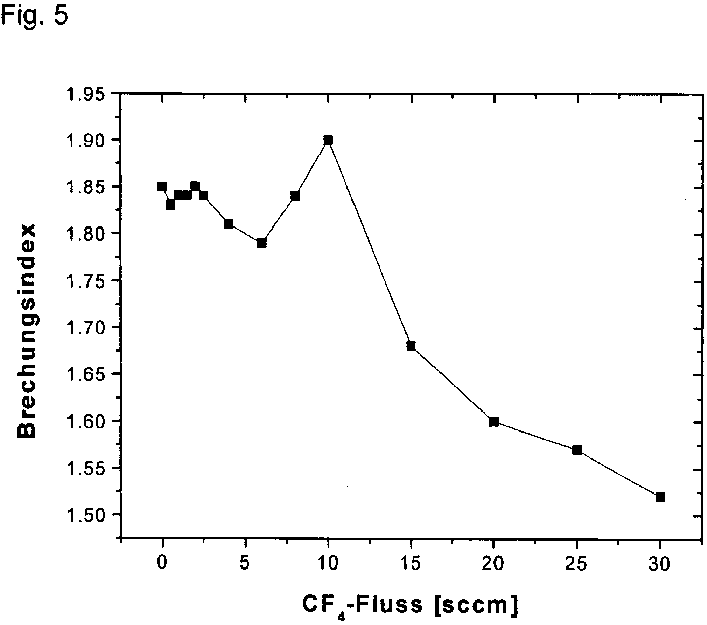

In Fig. 5 ist die Änderung des Brechungsindex der Siliziumoxynitrid-Schicht bei einer Wellenlänge von 550 nm in Abhängigkeit vom CF₄-Fluss (in Standardkubikzentimeter pro Minute, sccm) in der Siliziumoxynitrid-Schicht während des Sputterprozesses bei konstant gehaltenem Stickstoff- und Sauerstofffluss dargestellt. Die Messergebnisse machen deutlich, dass der Brechungsindex durch eine Änderung der Gaszusammensetzung gezielt verändert werden kann. Die Siliziumoxynitrid-Schicht kann bei einer Wellenlänge von 550 nm einen Brechungsindex zwischen 1.50 und 1.95 aufweisen.

Das Glasprodukt weist nach der Beschichtung mit der niedrig emittierenden, transparenten und leitfähigen Indiumzinnoxidschicht und der Deckschicht eine thermische Emissivität ε < 0.3 (insbesondere 0.25 (0,12) bei einem Schichtwiderstand von 20 (10) Ohm) auf. Somit kann die Eisbildung auf der Oberfläche des Glasprodukts bei typischen Beschlags- und Vereisungssituationen wirksam verhindert werden. Das Glasprodukt eignet sich somit insbesondere zur Herstellung mechanisch und chemisch stabiler Außenverglasungen oder Außenspiegel von Kraftfahrzeugen.

## Patentansprüche

1. Glasprodukt, umfassend ein Glassubstrat mit einer transparenten und leitfähigen Indiumzinnoxidschicht, die eine Deckschicht aufweist, welche eine Redoxbarriere für die Indiumzinnoxidschicht bildet, **dadurch gekennzeichnet, dass** die Indiumzinnoxidschicht durch gepulstes, hochionisierendes Hochleistungs-Magnetronsputtern (HPPMS), bei dem
- die Pulse des Magnetrons eine Peakleistungsdichte aufweisen, die größer als 1,5 kW/cm² ist,
- die Pulse des Magnetrons eine Zeitdauer haben, die s 200 µs ist, sowie
- der mittlere Stromflussdichteanstieg beim Zünden des Plasmas innerhalb eines Zeitintervall, das ≤ 0.025 ms ist, mindestens 106 A/(ms cm²) beträgt, erhalten wird, und die Indiumzinnoxidschicht eine kristalline Struktur aufweist, derart, dass der (222)-Reflex eines Röntgenbeugungsspektrums nach dem Erzeugen der Indiumzinnoxidschicht gegenüber dem Pulverspektrum von Indiumzinnoxid um maximal 1°, vorzugsweise um 0,3° bis 0,5°, in Richtung Druckspannung verschoben ist und nach dem Tempern um maximal 1 °, vorzugsweise um 0,2° bis 0,4°, in Richtung des Pulverspektrums verschoben ist.

2. Glasprodukt nach Anspruch 1, **dadurch gekennzeichnet, dass** etwa 80% der Korngröße der Indiumzinnoxidschicht kleiner als 30 nm, insbesondere kleiner als 25 nm ist.

3. Glasprodukt nach einem der Ansprüche 1 oder 2, **dadurch gekennzeichnet, dass** die lateralen Korngrößen der Indiumzinnoxidschicht vor und nach dem Tempern im Wesentlichen konstant sind.

4. Glasprodukt nach einem der Ansprüche 1 bis 3, **dadurch gekennzeichnet, dass** die Indiumzinnoxidschicht eine Schichtdicke aufweist, die ≤ 300 nm ist.

5. Glasprodukt nach einem der Ansprüche 1 bis 4, **dadurch gekennzeichnet, dass** die Indiumzinnoxidschicht eine Schichtdicke zwischen 130 und 150 nm, insbesondere eine Schichtdicke von etwa 140 nm aufweist.

6. Glasprodukt nach einem der Ansprüche 1 bis 5, **dadurch gekennzeichnet, dass** die Deckschicht eine Schichtdicke zwischen 5 nm und 60 nm aufweist.

7. Glasprodukt nach einem der Ansprüche 1 bis 6, **dadurch gekennzeichnet, dass** die Deckschicht bei einer Wellenlänge von 550 nm einen Brechungsindex zwischen 1.50 und 1.95 aufweist.

8. Glasprodukt nach einem der Ansprüche 1 bis 7, **dadurch gekennzeichnet, dass** die Deckschicht durch DC-Magnetronsputtern erhalten wird.

9. Glasprodukt nach einem der Ansprüche 1 bis 8, **dadurch gekennzeichnet, dass** die Deckschicht eine Siliziumoxynitrid-Schicht ist.

10. Glasprodukt nach Anspruch 9, **dadurch gekennzeichnet, dass** die Siliziumoxynitrid-Schicht mit Fluor und/oder Aluminium dotiert ist.

11. Glasprodukt nach Anspruch 9 oder 10, **dadurch gekennzeichnet, dass** die Siliziumoxynitrid-Schicht einen prozentualen Gehalt der Elemente:
| | | | |
|---|---|---|---|
| Silizium : | 25 bis 50% | Kohlenstoff : | 0 bis 15% |
| Sauerstoff : | 10 bis 30% | Fluor : | 0 bis 30% |
| Stickstoff : | 0 bis 50% | Aluminium : | 0 bis 20% |
aufweist.

12. Glasprodukt nach einem der Ansprüche 9 bis 11, **dadurch gekennzeichnet, dass** die Siliziumoxynitrid-Schicht einen prozentualen Gehalt der Elemente:
| | | | |
|---|---|---|---|
| Silizium : | 35% ± 5% | Kohlenstoff : | < 5% |
| Sauerstoff : | 18% ± 5% | Fluor : | < 5% |
| Stickstoff : | 35% ± 5% | Aluminium : | 4% ± 2% |
aufweist.

13. Glasprodukt nach einem der Ansprüche 1 bis 12, **dadurch gekennzeichnet, dass** das Glasprodukt nach einer Verschleißprüfung durch ein Reibradverfahren mit Streulichtmessung gemäß DIN 52 347 (1987) einen Streulichtanteil aufweist, der kleiner als 2,5 % ist.

## Claims

1. Glass product, comprising a glass substrate with a transparent and conductive indium tin oxide layer having a covering layer, which forms a redox barrier for the indium tin oxide layer, **characterized in that** the indium tin oxide layer is obtained by pulsed, highly ionizing high-power magnetron sputtering (HPPMS) in which
- the pulses of the magnetron have a peak power density that is greater than 1.5 kW/cm²,
- the pulses of the magnetron have a time duration that is ≤ 200 µs, and
- the mean current flow density rise upon ignition of the plasma within a time interval that is ≤ 0.025 ms is at least 106 A/(ms cm²),
and the indium tin oxide layer has a crystalline structure, in such a way that the (222)-reflection of an X-ray diffraction spectrum after the production of the indium tin oxide layer is shifted relative to the powder spectrum of indium tin oxide by a maximum of 1°, preferably by 0.3° to 0.5°, in the direction of compressive stress and is shifted after heat treatment by a maximum of 1°, preferably by 0.2° to 0.4°, in the direction of the powder spectrum.

2. Glass product according to Claim 1, **characterized in that** approximately 80% of the grain size of the indium tin oxide layer is less than 30 nm, in particular less than 25 nm.

3. Glass product according to either of Claims 1 and 2, **characterized in that** the lateral grain sizes of the indium tin oxide layer before and after the heat treatment are substantially constant.

4. Glass product according to any of Claims 1 to 3, **characterized in that** the indium tin oxide layer has a layer thickness that is ≤ 300 nm.

5. Glass product according to any of Claims 1 to 4, **characterized in that** the indium tin oxide layer has a layer thickness of between 130 and 150 nm, in particular a layer thickness of approximately 140 nm.

6. Glass product according to any of Claims 1 to 5, **characterized in that** the covering layer has a layer thickness of between 5 nm and 60 nm.

7. Glass product according to any of Claims 1 to 6, **characterized in that** the covering layer has a refractive index of between 1.50 and 1.95 at a wavelength of 550 nm.

8. Glass product according to any of Claims 1 to 7, **characterized in that** the covering layer is obtained by DC magnetron sputtering.

9. Glass product according to any of Claims 1 to 8, **characterized in that** the covering layer is a silicon oxynitride layer.

10. Glass product according to Claim 9, **characterized in that** the silicon oxynitride layer is doped with fluorine and/or aluminum.

11. Glass product according to Claim 9 or 10, **characterized in that** the silicon oxynitride layer has a percentage content of the elements:
| | | | |
|---|---|---|---|
| silicon: | 25 to 50% | carbon: | 0 to 15% |
| oxygen: | 10 to 30% | fluorine: | 0 to 30% |
| nitrogen: | 0 to 50% | aluminum: | 0 to 20%. |

12. Glass product according to any of Claims 9 to 11, **characterized in that** the silicon oxynitride layer has a percentage content of the elements:
| | | | |
|---|---|---|---|
| silicon: | 35% ± 5% | carbon: | < 5% |
| oxygen: | 18% ± 5% | fluorine: | < 5% |
| nitrogen: | 35% ± 5% | aluminum: | 4% ± 2%. |

13. Glass product according to any of Claims 1 to 12, **characterized in that** the glass product has a scattered-light component that is less than 2.5% after a wear test by means of an abrasion wheel method with scattered light measurement according to DIN 52 347 (1987).

## Revendications

1. Produit de verre, comprenant un substrat de verre doté d'une couche transparente et conductrice d'oxyde d'indium et d'étain qui présente une couche de recouvrement qui forme une barrière redox pour la couche d'oxyde d'indium et d'étain, **caractérisé en ce que**
la couche d'oxyde d'indium et d'étain est obtenue par pulvérisation pulsée à magnétron de haute puissance et à forte ionisation (HPPMS), dans laquelle
les pulsations du magnétron présentent une densité de puissance de pointe supérieure à 1,5 kW/cm², les impulsions du magnétron ont une durée ≤ 200 µs et
l'augmentation moyenne de la densité de flux de courant lors de l'allumage du plasma est d'au moins 106 A/(ms cm²) pendant un intervalle de temps de ≤ 0,025 ms et
**en ce que** la couche d'oxyde d'indium et d'étain présente une structure cristalline telle qu'après la formation de la couche d'oxyde d'indium et d'étain, la réflexion (222) d'un spectre de diffraction des rayons X par rapport au spectre de poudre d'oxyde d'indium et d'étain est décalée d'au plus 1° et de préférence de 0,3° à 0,5° en direction de la contrainte de compression et qu'après la trempe, elle est déplacée d'au plus 1° et de préférence de 0,2° à 0,4° en direction du spectre de poudre.

2. Produit de verre selon la revendication 1, **caractérisé en ce qu'**environ 80 % de la granulométrie de la couche d'oxyde d'indium et d'étain sont inférieurs à 30 nm et en particulier inférieurs à 25 nm.

3. Produit de verre selon l'une des revendications 1 ou 2, **caractérisé en ce que** les granulométries latérales de la couche d'oxyde d'indium et d'étain restent essentiellement constantes avant et après la trempe.

4. Produit de verre selon l'une des revendications 1 à 3, **caractérisé en ce que** la couche d'oxyde d'indium et d'étain présente une épaisseur ≤ 300 nm.

5. Produit de verre selon l'une des revendications 1 à 4, **caractérisé en ce que** la couche d'oxyde d'indium et d'étain présente une épaisseur comprise entre 130 et 150 nm et en particulier une épaisseur d'environ 140 nm.

6. Produit de verre selon l'une des revendications 1 à 5, **caractérisé en ce que** la couche de recouvrement présente une épaisseur comprise entre 5 nm et 60 nm.

7. Produit de verre selon l'une des revendications 1 à 6, **caractérisé en ce qu'**à une longueur d'onde de 550 nm, la couche de recouvrement présente un indice de réfraction compris entre 1,50 et 1,95.

8. Produit de verre selon l'une des revendications 1 à 7, **caractérisé en ce que** la couche de recouvrement est obtenue par pulvérisation à magnétron en courant continu.

9. Produit de verre selon l'une des revendications 1 à 8, **caractérisé en ce que** la couche de recouvrement est une couche d'oxynitrure de silicium.

10. Produit de verre selon l'une des revendications selon la revendication 9, **caractérisé en ce que** la couche d'oxynitrure de silicium et dopée au fluor et/ou à l'aluminium.

11. Produit de verre selon l'une des revendications 9 ou 10, **caractérisé en ce que** la couche d'oxynitrure de silicium présente les teneurs en pourcentage suivantes pour les éléments :
| | |
|---|---|
| silicium : | 25 à 50 % |
| oxygène : | 10 à 30 % |
| azote : | 0 à 50 % |
| carbone : | 0 à 15 % |
| fluor : | 0 à 30 % |
| aluminium : | 0 à 20 %. |

12. Produit de verre selon l'une des revendications 9 à 11, **caractérisé en ce que** la couche d'oxynitrure de silicium présente les teneurs en pourcentage suivantes pour les éléments :
| | |
|---|---|
| silicium : | 35 % ± 5 % |
| oxygène : | 18 % ± 5 % |
| azote : | 35 % ± 5 % |
| carbone : | < 5 % |
| fluor : | < 5 % |
| aluminium : | 4 % ± 2 %. |

13. Produit de verre selon l'une des revendications 1 à 12, **caractérisé en ce que** le produit de verre présente une teneur en lumière diffuse inférieure à 2,5 % dans un essai d'usure par un procédé à roue abrasive, avec mesure de la lumière diffuse selon la norme DIN 52 347 (1987).
